# EUROPEAN PATENT APPLICATION

(11) **EP 4 123 421 A1**
(43) Date of publication of application: **25.01.2023**
(21) Application number: 22175906.1
(22) Date of filing: 27.05.2022
(51) Int. Cl.: G06F 1/20, F28F 1/00

(54) **WATER-COOLED RADIATOR**

(71) Applicant: Dongguan Bingdian Intelligent Science & Technology Co., Ltd., Dongguan City, Guangdong Province (CN)
(72) Inventor: ZHANG, Fengqi, Tongliao City (CN)
(74) Representative: Lin Chien, Mon-Yin

(57) **Abstract**

The present application provides a water-cooled radiator, when cooling liquid enters a first water cavity from a liquid inlet pipe, and enters a third water cavity from a first water-passage hole, and since the heat-dissipating fin group is arranged in the third water cavity, and the first water-passage hole extends perpendicular to the length direction of the heat-dissipating fin group, the cooling liquid will enter the gap of multiple heat-dissipating fins in the heat-dissipating fin group and flow to both ends along the length direction of the heat-dissipating fin group, and flow to a second water cavity from a second water-passage hole, and to a heat-dissipating unit through a liquid outlet pipe, so as to realize water circulation.

## Description

### TECHNICAL FIELD

The present invention relates to the technology field of radiators, and in particular to a water-cooled radiator.

### BACKGROUND

At present, with the rapid development of electronic technology and people's needs in life, entertainment and work, computer has become an indispensable necessity in people' s daily life. Nowadays, people are inseparable from computers most of the time, whether for entertainment or work. With the rapid development of electronic technology, the performance of computers has also been improved rapidly. The improvement of performance is accompanied by the increase of heat generation, which has a serious impact on the performance and service life of the computer.

The existing heat-dissipating systems mainly include an air-cooled heat-dissipating system and a water-cooled heat-dissipating system. The water-cooled heat-dissipating system has been widely used in the heat-dissipating treatment of CPU because of the remarkable heat-dissipating performance and low noise thereof, and has become one of the important development trends of a computer cooling system.

However, in the prior art, due to the single water circuit design of the water-cooled heat-dissipating system, the contact area between the cooling liquid inside and the radiator is small, so that it is easy to have a poor heat dissipation effect and low heat-dissipating efficiency. Moreover, the water-cooled radiator sets the pump body inside the equipment, so that the installation and maintenance are very inconvenient.

### SUMMARY

In order to solve the above problems, the present invention provides a water-cooled radiator, which ensures that the cooling liquid can be in contact with multiple heat-dissipating fins in the heat-dissipating fin group to the greatest extent, increases the contact area between the cooling liquid and the heat-dissipating fin group, and improves the heat dissipation effect.

For achieving the above objects, the technical solution of the present invention is as follows: a water-cooled radiator, comprising a heat-absorbing unit connected with a heat-dissipating surface of a processor and a heat-dissipating unit communicated with the heat-absorbing unit, characterized in that: the heat-absorbing unit includes an outer shell, a bottom shell, and a waterway cover plate and a heat-absorbing bottom plate connected in sequence from top to bottom; wherein the bottom shell is provided with a liquid inlet pipe and a liquid outlet pipe communicated with the heat-dissipating unit, and a pump body is arranged between the heat-dissipating unit and the liquid inlet pipe; a first water cavity connected with the liquid inlet pipe and a second water cavity flowing with the liquid outlet pipe are encircled between the bottom shell and the waterway cover plate, and the first water cavity and the second water cavity are independent of each other; the heat-absorbing bottom plate and the waterway cover plate encircle a third water cavity, wherein a surface of the heat-absorbing bottom plate is fixedly provided with a heat-dissipating fin group, the heat-dissipating fin group is arranged in the third water cavity, a surface of the waterway cover plate is provided with a first water-passage hole for connecting the first water cavity and the third water cavity, and a second water-passage hole for connecting the second water cavity and the third water cavity, wherein the first water-passage hole extends along a direction perpendicular to a length of the heat-dissipating fin group, and the second water-passage hole of the waterway cover plate is arranged at both ends of the corresponding heat-dissipating fin group.

Furthermore, a liquid inlet is arranged at a connection between the liquid inlet pipe and the first water cavity; and a liquid outlet is arranged at a connection between the liquid inlet pipe and the second water cavity.

Furthermore, a bottom of the bottom shell is provided with a water-passage trough, and the water-passage trough is provided with a "Ω" shaped water baffle, wherein an inner wall of the water-passage trough, an inner side of the water baffle and the waterway cover plate encircle the first water cavity, and the inner wall of the water-passage trough, an outer side of the water baffle and the waterway cover plate encircle the second water cavity; the inner wall of the water-passage trough is provided with a limit bump, an outer side of the waterway cover plate is provided with a limit groove corresponding to the limit bump, the waterway cover plate is arranged in the water-passage trough, and the limit bump is inserted in the limit groove.

Furthermore, the bottom surface of the waterway cover plate is provided with a placement groove, the heat-absorbing bottom plate is arranged at a bottom of the waterway cover plate, and the heat-dissipating fin group is arranged in the placement groove, wherein the first water-passage hole is arranged in a middle of the bottom of the placement groove, the second water-passage hole is arranged on both sides of the bottom of the placement groove, and a depth of the placement groove is equal to a height of the heat-dissipating fin group.

Furthermore, a sealing groove is arranged at a connection between the bottom shell and the heat-absorbing bottom plate, a sealing ring is embedded in the sealing groove, and a cross-sectional area of the sealing ring is greater than that of the sealing groove.

Furthermore, the heat-absorbing unit further includes an arc-shaped support, wherein both ends of the arc-shaped support are provided with hooks, wherein an outer surface of the bottom shell is provided with a circle of first bumps, the outer surface of the bottom shell is evenly provided with a plurality of second bumps under the first bumps along a circumferential direction, the outer surface of the bottom shell located between the first bump and the second bump is provided with a slot corresponding to the hook, and the arc-shaped support is clamped between the first bump and the second bump, and is hooked with the slot through hooks at both ends to realize connection with the bottom shell.

Furthermore, the heat-dissipating unit includes a heat-dissipating water row, a first adapter, a second adapter, a first pipe sleeve, a second pipe sleeve, a first braided pipe and a second braided pipe, wherein the liquid outlet pipe is communicated with the first adapter, the first adapter is communicated with one end of the first braided pipe through the first pipe sleeve, and the other end of the first braided pipe is communicated with the heat-dissipating water row; the liquid inlet pipe is connected with the second adapter, the second adapter is connected with one end of the second braided pipe through the second pipe sleeve, the other end of the second braided pipe is connected with a water outlet end of the pump body, and a water inlet end of the pump body is communicated with the heat-dissipating water row; the heat-dissipating unit further includes a pump body cover, the pump body cover includes an upper cover and a lower cover, the pump body is located in a cavity encircled by the upper cover and the lower cover, and the second braided pipe is communicated with the heat-dissipating water row through the cavity.

Furthermore, the outer shell includes a transparent cover plate, an upper mirror cover, an aluminum upper cover, a transparent light guide, a middle trim plate, a lower mirror cover, a LOGO support, a lower cover and a PCB board, wherein the transparent cover plate, the aluminum upper cover, the middle trim plate and the lower cover are connected in sequence from top to bottom, and the lower cover is covered on the surface of the bottom shell; the upper mirror cover is arranged between the transparent cover plate and the aluminum upper cover, the transparent light guide is arranged between the aluminum upper cover and the middle trim plate, the lower mirror cover and the LOGO support are arranged between the middle trim plate and the lower cover, and the PCB board is arranged between the lower cover and the bottom shell.

Furthermore, the outer shell includes a fan body and a cylindrical heat-dissipating shell sleeved on the bottom shell, wherein an outer wall at an upper end of the heat-dissipating shell is provided with a plurality of air inlet holes along the circumferential direction thereof, and an outer wall at a lower end of the heat-dissipating shell is provided with a plurality of air outlet holes along the circumferential direction thereof; the fan body is arranged on the surface of the bottom shell, and the fan body is located between a height of the air inlet hole and a height of the air outlet hole.

Furthermore, an inner wall of a fan mounting sleeve is provided with an LED lamp module, wherein the LED lamp module includes a red LED lamp, a blue LED lamp, a green LED lamp and a white LED lamp; the upper end of the heat-dissipating shell is provided with an opening, and the opening is covered with a cover plate of transparent material.

The technical advantages of the present invention are as follows: 1. when the cooling liquid enters the first water cavity from the liquid inlet pipe, and then enters the third water cavity from the first water-passage hole, and meanwhile, since the heat-dissipating fin group is arranged in the third water cavity, and the first water-passage hole extends perpendicular to the length direction of the heat-dissipating fin group, the cooling liquid will enter the gap of multiple heat-dissipating fins in the heat-dissipating fin group and flow to both ends along the length direction of the heat-dissipating fin group, and then flow to the second water cavity from the second water-passage hole, and to the heat-dissipating unit through the liquid outlet pipe, so as to realize water circulation. Therefore, it ensures that the cooling liquid can be in contact with multiple heat-dissipating fins in the heat-dissipating fin group to the greatest extent, increases the contact area between the cooling liquid and the heat-dissipating fin group and improves the heat dissipation effect. Moreover, because flow of the water path is from the first water cavity to the third water cavity and then to the second water cavity, the entire water path flows in from top to bottom and then flows out from bottom to top, thus, the cooling liquid level will certainly be higher than the height of the heat-dissipating fin group, and water circulation is realized. Thus, it can ensure the complete contact between the cooling liquid and the heat-dissipating fin group and improve the heat dissipation effect.

2. In the present application, a pump body is arranged between the heat-dissipating unit and the liquid inlet pipe. Compared with the traditional built-in heat-absorbing unit, the pump body of the present application adopts the method of external connection, which is more convenient for installation and connection, superior in performance and more convenient for maintenance. 3. While maintaining the most basic water-cooling effect, the present application also provides a cooling fan, the outer wall at the upper end of the heat-dissipating shell is provided with multiple air inlet holes along the circumferential direction thereof, and the outer wall at the lower end of the heat-dissipating shell is provided with multiple air outlet holes along circumferential direction thereof. The heat-dissipating shell is sleeved on the bottom shell, the fan body is arranged on the surface of the bottom shell, and the fan body is located between the height of the air inlet hole and the height of the air outlet hole. Then the external air enters the heat-dissipating shell from the air inlet hole at the upper end of the heat-dissipating shell and is discharged from the air outlet hole at the lower end of the heat-dissipating shell. When the heat-absorbing unit works, it is close to the heat-dissipating surface of the CPU, thus the air discharged from the air outlet hole can cool the heat dissipation of various electronic components such as MOS tubes and memory bars around the motherboard CPU. By using the device of the present application, the heat dissipation and cooling of the CPU and various electronic components such as MOS tubes and memory bars around the motherboard CPU can be realized, which can greatly improve the heat-dissipating efficiency and prolong the service life of the motherboard.

### BRIEF DESCRIPTION OF THE DRAWINGS

Fig. 1 is a schematic diagram of a three-dimensional explosion structure of the overall equipment of the present invention.
Fig. 2 is an explosive diagram of the overall equipment of the present invention.
Fig. 3 is a top view of the assembled bottom shell, waterway cover plate and heat-absorbing bottom plate of the present invention.
Fig. 4 is a cross-sectional view along section line C-C in Fig. 3 of the present invention.
Fig. 5 is a cross-sectional view along section line E-E in Fig. 3 of the present invention.
Fig. 6 is a schematic three-dimensional structural diagram of the bottom shell of the present invention.
Fig. 7 is a bottom view of the bottom shell of the present invention.
Fig. 8 is a schematic three-dimensional structural diagram of the waterway cover plate of the present invention.
Fig. 9 is a schematic structural diagram of the pump body of the present invention.
Fig. 10 is a schematic diagram of an explosion structure in the second embodiment of the present invention.
Fig. 11 is a schematic structural diagram of the outer shell in the second embodiment of the present invention.
Fig. 12 is a schematic structural diagram after omitting the heat-dissipating shell in FIG. 11.

Description of reference numerals:
10 Shell; 101 Transparent cover; 102 Upper mirror; 103 Aluminum upper cover; 104 Transparent light guide; 105 Middle trim plate; 106 Lower mirror cover; 107 LOGO support; 108 Lower cover; 109 PCB board; 11 Bottom shell; 111 Water-passage trough; 112 Water baffle; 113 Liquid outlet; 114 Liquid inlet; 115 Second bump; 116 First bump; 117 Limit bump; 118 Liquid inlet pipe; 119 Liquid outlet pipe; 12 Waterway cover plate; 121 Placement groove; 122 First water-passage hole; 123 Second water-passage hole; 124 Limit groove; 1111 First water cavity; 1112 Second water cavity; 1113 Third water cavity; 13 Sealing ring; 14 Heat-absorbing bottom plate; 141 Heat-dissipating fin group; 151 First adapter; 152 Second adapter; 161 First pipe sleeve; 162 Second pipe sleeve; 17 Connector sealing ring; 18 Arc-shaped support; 21 Heat-dissipating water row; 22 Pump body; 221 Drive motor; 222 Impeller tube; 223 Impeller; 224 Water pump tee; 225 Shockproof sleeve; 231 Lower cover; 232 Upper cover; 241 First braided pipe; 242 Second braided pipe; 41 Cover plate; 42 Heat-dissipating shell; 421 Air inlet hole; 422 Air outlet hole; 423 Bump; 425 Fan blades; 43 Fan body; 431 Fan mounting sleeve; 110 Connecting column.

### DETAILED DESCRIPTION OF PREFERRED EMBODIMENTS

### Embodiment 1

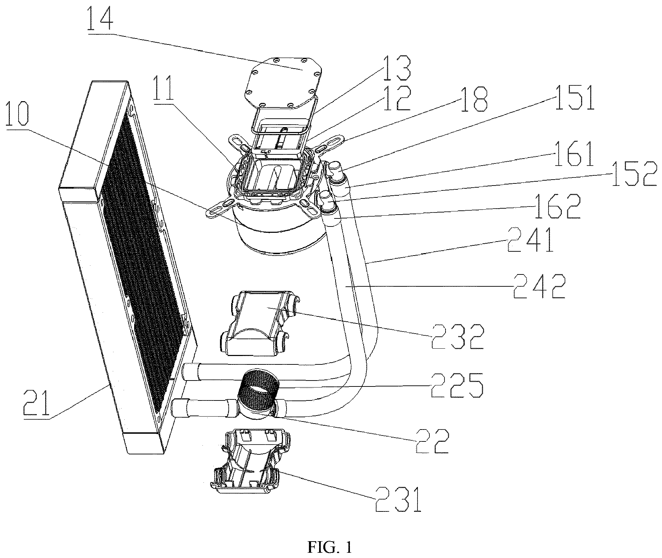

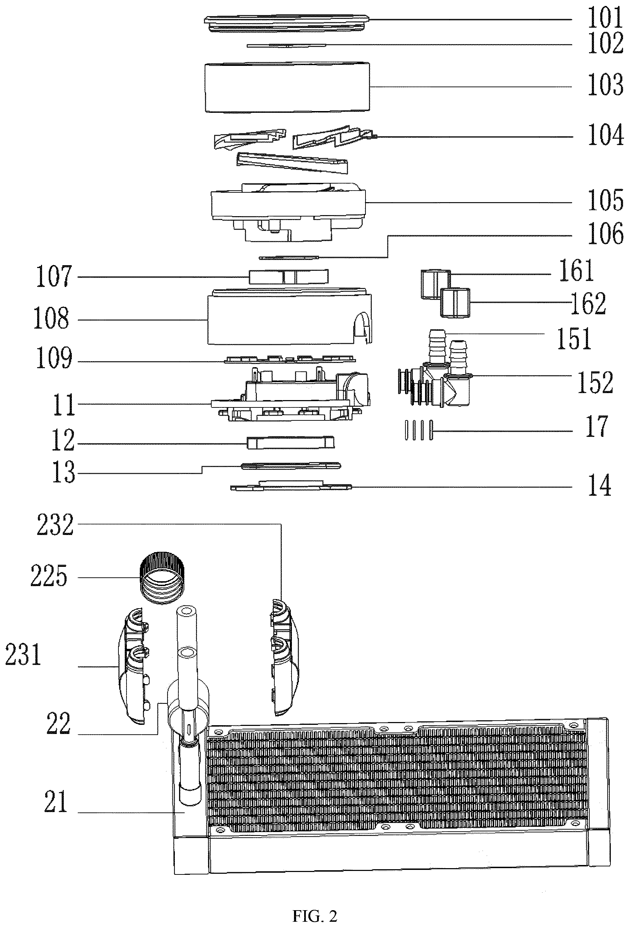

As shown in Figs. 1-9, the present invention relates to a water-cooled radiator, which includes a heat-absorbing unit connected with a heat-dissipating surface of a processor and a heat-dissipating unit communicated with the heat-absorbing unit. The heat-absorbing unit includes an outer shell 10, a bottom shell 11, and a waterway cover plate 12 and a heat-absorbing bottom plate 14 connected in sequence from top to bottom. The bottom shell 11 is provided with a liquid inlet pipe 118 and a liquid outlet pipe 119 communicated with the heat-dissipating unit, and a pump body 22 is arranged between the heat-dissipating unit and the liquid inlet pipe 118. A first water cavity 1111 connected with the liquid inlet pipe 118 and a second water cavity 1112 flowing with the liquid outlet pipe 119 are encircled between the bottom shell 11 and the waterway cover plate 12, and the first water cavity 1111 and the second water cavity 1112 are independent of each other. The heat-absorbing bottom plate 14 and the waterway cover plate 12 encircle a third water cavity 1113, the surface of the heat-absorbing bottom plate 14 is fixedly provided with a heat-dissipating fin group 141, the heat-dissipating fin group 141 is arranged in the third water cavity 1113, a surface of the waterway cover plate 12 is provided with a first water-passage hole 122 for connecting the first water cavity 1111 and the third water cavity 1113, and a second water-passage hole 123 for connecting the second water cavity 1112 and the third water cavity 1113. The first water-passage hole 122 extends along a direction perpendicular to a length of the heat-dissipating fin group 141, and the second water-passage hole 123 of the waterway cover plate 12 is arranged at both ends of the corresponding heat-dissipating fin group 141.

When the cooling liquid enters the first water cavity 1111 from the liquid inlet pipe 118, and then enters the third water cavity 1113 from the first water-passage hole 122, and meanwhile, since the heat-dissipating fin group 141 is arranged in the third water cavity 1113, and the first water-passage hole 122 extends perpendicular to the length direction of the heat-dissipating fin group 141, the cooling liquid will enter the gap of multiple heat-dissipating fins in the heat-dissipating fin group 141 and flow to both ends along the length direction of the heat-dissipating fin group 141, and then flow to the second water cavity 1112 from the second water-passage hole 123, and to the heat-dissipating unit through the liquid outlet pipe 119, so as to realize water circulation. Therefore, it ensures that the cooling liquid can be in contact with multiple heat-dissipating fins in the heat-dissipating fin group 141 to the greatest extent, increases the contact area between the cooling liquid and the heat-dissipating fin group 141 and improves the heat dissipation effect. Moreover, because flow of the water path is from the first water cavity 1111 to the third water cavity 1113 and then to the second water cavity 1112, the entire water path flows in from top to bottom and then flows out from bottom to top, thus, the cooling liquid level will certainly be higher than the height of the heat-dissipating fin group 141, and water circulation is realized. Thus, it can ensure the complete contact between the cooling liquid and the heat-dissipating fin group 141 and improve the heat dissipation effect.

In the present application, a pump body 22 is arranged between the heat-dissipating unit and the liquid inlet pipe 118. Compared with the traditional built-in heat-absorbing unit, the pump body 22 of the present application adopts the method of external connection, which is more convenient for installation and connection, superior in performance and more convenient for maintenance.

As shown in Figs. 1-9, the working process of the present invention includes the followings:
Driven by the pump body 22, the cooling liquid enters the first water cavity 1111 from the liquid inlet pipe 118, and then enters the third water cavity 1113 through the first water-passage hole 122. Therefore, the cooling liquid will enter the gap of multiple heat-dissipating fins in the heat-dissipating fin group 141 located in the third water cavity 1113, flow to both ends of the heat-dissipating fin group 141 along the length direction of the heat-dissipating fin group 141, and take away the heat of the heat-absorbing bottom plate 14. Moreover, the cooling liquid located in the third water cavity 1113 flows into the second water cavity 1112 from the second water-passage hole 123, flows out of the liquid outlet pipe 119, transmits the cooling liquid to the heat-dissipating unit for further heat dissipation, and then recirculates into the liquid inlet pipe 118.

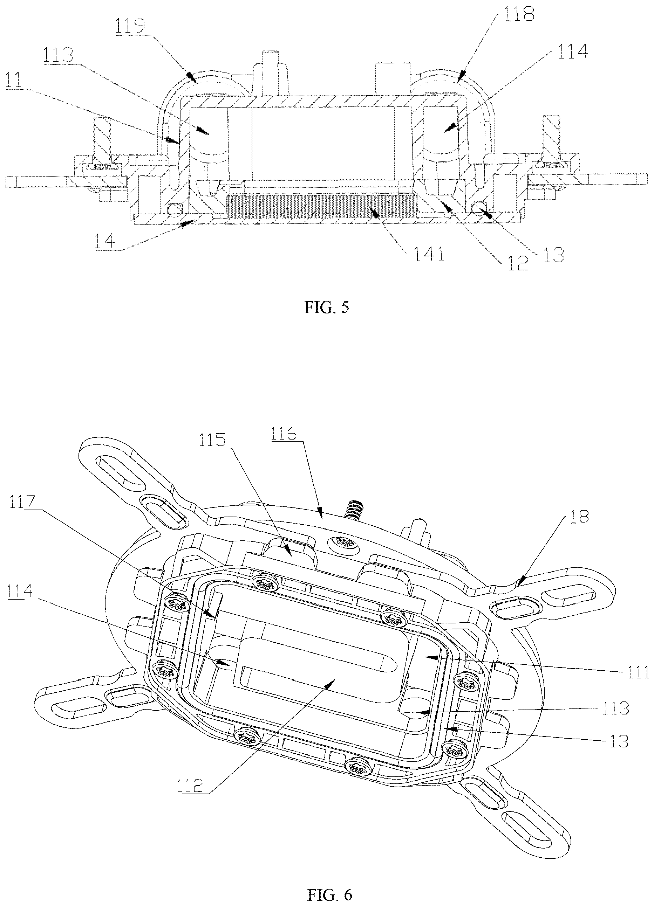

As shown in Fig. 5, furthermore, a liquid inlet 114 is arranged at the connection between the liquid inlet pipe 118 and the first water cavity 1111, and a liquid outlet 113 is arranged at the connection between the liquid outlet pipe 119 and the second water cavity 1112.

As shown in Figs. 6-7, furthermore, the bottom of the bottom shell 11 is provided with a water-passage trough 111, and the water-passage trough 111 is provided with a "Ω" shaped water baffle 112, the inner wall of the water-passage trough 111, the inner side of the water baffle 112 and the waterway cover plate 12 encircle the first water cavity 1111, and the inner wall of the water-passage trough 111, the outer side of the water baffle 112 and the waterway cover plate 12 encircle the second water cavity 1112. In this embodiment, the first water cavity 1111 is located in the middle of the water-passage trough 111 and is in an "L" shape. The second water cavity 1112 is in a "U" shape.

As shown in Figs. 6-7, furthermore, the inner wall of the water-passage trough 111 is provided with a limit bump 117, the outer side of the waterway cover plate 12 is provided with a limit groove 124 corresponding to the limit bump 117, the waterway cover plate 12 is arranged in the water-passage trough 111, and the limit bump 117 is inserted in the limit groove 124. In this embodiment, the limit bump 117 is set on the inner wall of the water-passage trough 111, which can play the role of error prevention, and the cooperation between the limit bump 117 and the limit groove 124 can play a stable role, which can avoid the deviation of the waterway cover plate 12 during operation.

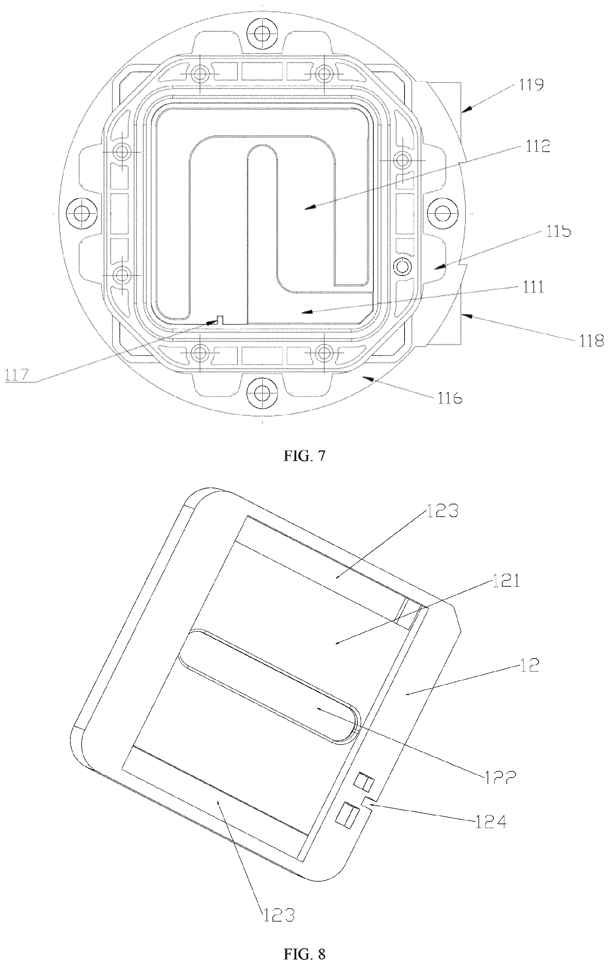

As shown in Fig. 8, furthermore, the bottom surface of the waterway cover plate 12 is provided with a placement groove 121, the heat-absorbing bottom plate 14 is arranged at the bottom of the waterway cover plate 12, and the heat-dissipating fin group 141 is arranged in the placement groove 121. In order to improve the heat dissipation effect of the heat-dissipating fin group 141, in this embodiment, the first water-passage hole 122 is arranged in the middle of the bottom of the placement groove 121 and aligned with the center of the heat-dissipating fin group 141. Therefore, it can be ensured that the flow rate of the cooling liquid to both ends of the heat-dissipating fin group 141 is the same, so as to avoid the poor heat dissipation effect caused by the different flow rates of the cooling liquid at both ends of the heat-dissipating fin groupl41. The second water-passage hole 123 is arranged on both sides of the bottom of the placement groove 121 and aligned with both ends of the heat-dissipating fin group 141, so normal flow of the water path can be ensured. Moreover, in this embodiment, the depth of the placement groove 121 is equal to the height of the heat-dissipating fin group 141, that is, the heat-dissipating fin group 141 is close to the bottom of the placement groove 121, so as to ensure that when the cooling liquid flows out of the first water-passage hole 122, it can directly enter the gap of the heat-dissipating fin group 141. Assuming that the heat-dissipating fin group 141 is not close to the bottom of the placement groove 121, that is, when the cooling liquid flows out of the first water-passage hole 122, it may flow to the space between the placement groove 121 and the heat-dissipating fin group 141. Finally, only a small part of the cooling liquid contacts the heat-dissipating fin group 141, and the heat dissipation effect is reduced.

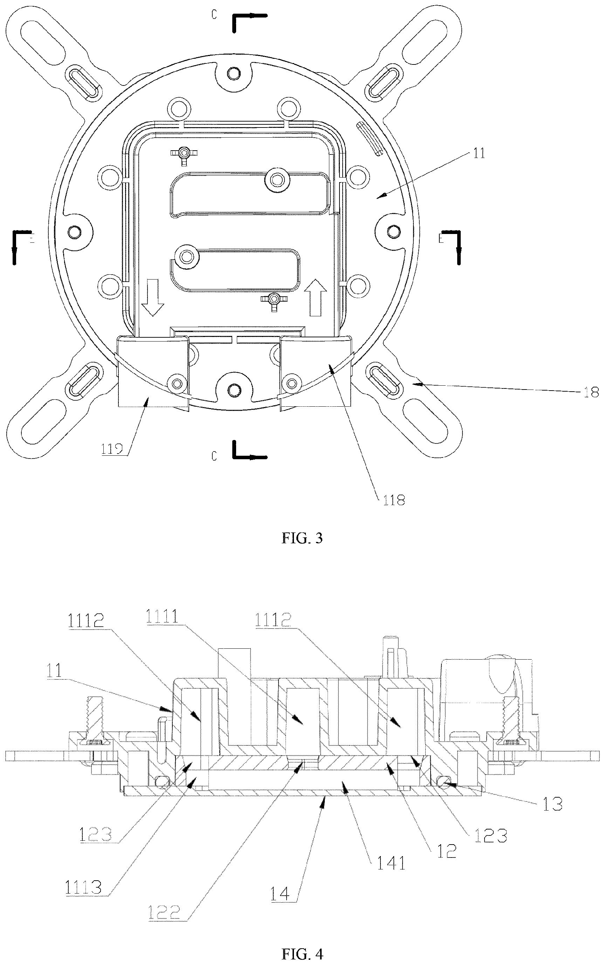

As shown in Figs. 4-7, furthermore, a sealing groove is arranged at the connection between the bottom shell 11 and the heat-absorbing bottom plate 14, and a sealing ring 13 is embedded in the sealing groove. The cross-sectional area of the sealing ring 13 is greater than that of the sealing groove. By setting the cross-sectional area of the sealing ring being greater than that of the sealing groove, the tightness can be increased and the probability of liquid leakage can be reduced.

As shown in Figs. 4-7, furthermore, the heat-absorbing unit further includes an arc-shaped support 18, both ends of the arc-shaped support 18 are provided with hooks. The outer surface of the bottom shell 11 is provided with a circle of first bumps 116, and the outer surface of the bottom shell 11 is evenly provided with multiple second bumps 115 under the first bumps 116 along the circumferential direction. The outer surface of the bottom shell located between the first bump 116 and the second bump 115 is provided with a slot corresponding to the hook. The arc-shaped support 18 is clamped between the first bump 116 and the second bump 115, and is hooked with the slot through the hooks at both ends to realize the connection with the bottom shell 11. In this embodiment, the four directions of the bottom shell 11 are designed with slots. When the arc-shaped support 18 is clamped in the space between the first bump 116 and the second bump 115, and make the hooks and slots at both ends of the arc-shaped bracket 18 hook, the arc-shaped support 18 can be well fixed and combined with the bottom shell 11, eliminating the cumbersome structural method of fixing with screws. Moreover, the first bump 116 and the second bump 115 limit the arc-shaped support 18.

As shown in Fig. 1-2, furthermore, the heat-dissipating unit includes a heat-dissipating water row 21, a first adapter 151, a second adapter 152, a first pipe sleeve 161, a second pipe sleeve 162, a first braided pipe 241 and a second braided pipe 242. The liquid outlet pipe 119 is communicated with the first adapter 151, the first adapter 151 is communicated with one end of the first braided pipe 241 through the first pipe sleeve 161, and the other end of the first braided pipe 241 is communicated with the heat-dissipating water row 21. The liquid inlet pipe 118 is connected with the second adapter 152, the second adapter 152 is connected with one end of the second braided pipe 242 through the second pipe sleeve 162, the other end of the second braided pipe 242 is connected with a water outlet end of the pump body 22, and a water inlet end of the pump body 22 is communicated with the heat-dissipating water row 21. In this embodiment, the connection between the first adapter 151 and the liquid outlet pipe 119 and the connection between the second adapter 152 and the liquid inlet pipe 118 are provided with a connector sealing ring 17, which can enhance the air tightness of the liquid outlet pipe 119 and the liquid inlet pipe 118 to avoid leakage.

As shown in Fig. 1-2, furthermore, the heat-dissipating unit further includes a pump body cover, the pump body cover includes an upper cover 232 and a lower cover 231. The upper cover 232 and the lower cover 231 are fixed by screw-free upper and lower hooks. The pump body 22 is located in a cavity encircle by the upper cover 232 and the lower cover 231, and the second braided pipe 242 is communicated with the heat-dissipating water row 21 through the cavity.

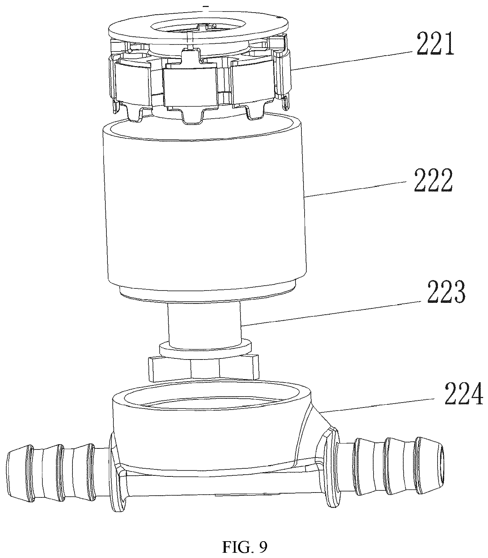

As shown in Fig. 9, in this embodiment, the pump body 22 includes an impeller pipe 222, a drive motor 221, an impeller 223 and a water pump tee 224. The impeller pipe 222 is connected with one end of the water pump tee 224, the drive motor 221 and the impeller 223 are arranged in the impeller pipe 222, the output shaft of the drive motor 221 is connected with the impeller 223, and the impeller 223 extends into the water pump tee 224 along the length thereof. The water outlet end of the water pump tee 224 is connected with the second braided pipe 242, and the water inlet end of the water pump tee 224 is communicated with the heat-dissipating water row 21. Moreover, a shockproof sleeve 225 is sleeved on the surface of the impeller pipe 222 to cover the water pump to prevent noise caused by the operation of the water pump and the vibration of the pump body cover.

As shown in Fig. 1-2, furthermore, the outer shell 10 includes a transparent cover plate 101, an upper mirror 102, an aluminum upper cover 103, a transparent light guide 104, a middle trim plate 105, a lower mirror cover 106, a LOGO support 107, a lower cover 108 and a PCB board 109. The transparent cover plate 101, the aluminum upper cover 103, the middle trim plate 105 and the lower cover 108 are connected in sequence from top to bottom, and the lower cover 108 is covered on the surface of the bottom shell. The upper mirror 102 cover is arranged between the transparent cover plate 101 and the aluminum upper cover 103, the transparent light guide 104 is arranged between the aluminum upper cover 103 and the middle trim plate 105, the lower mirror cover 106 and the LOGO support 107 are arranged between the middle trim plate 105 and the lower cover 108, and the PCB board 109 is arranged between the lower cover 108 and the bottom shell 11.

### Embodiment 2

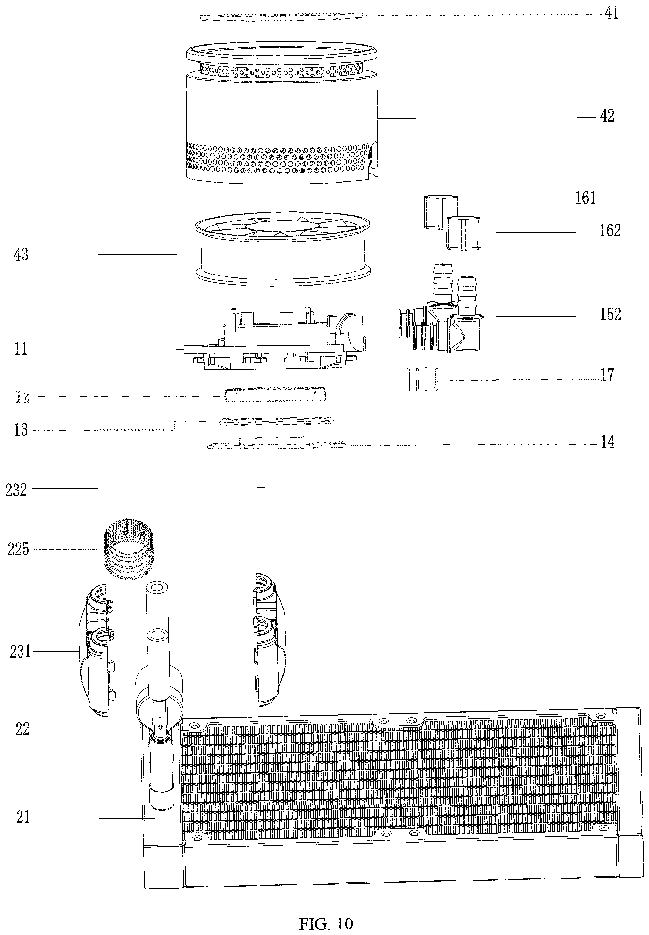

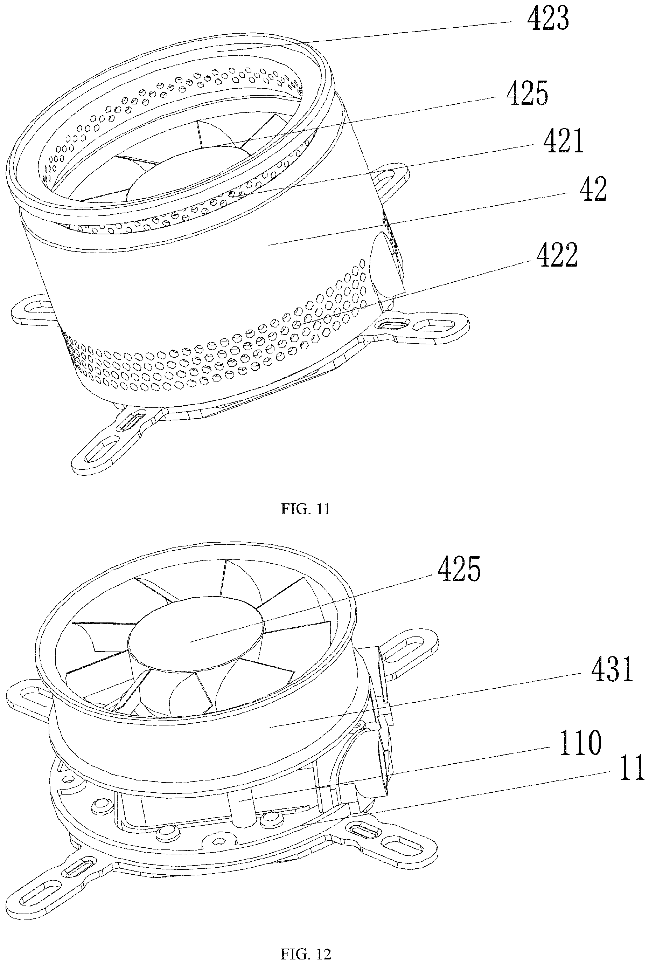

As shown in Figs. 10-12, the structure of the embodiment two is the same as that of most of the specific embodiments, and only different types of shells are equipped. The outer shell 10 in embodiment two is equipped with a cooling fan unit. The outer shell of embodiment two includes a fan body 43 and a cylindrical heat-dissipating shell 42 sleeved on the bottom shell 11, the outer wall of the upper end of the heat-dissipating shell 42 is provided with multiple air inlet holes 421 along the circumference thereof. The outer wall at the lower end of the heat-dissipating shell 42 is provided with multiple air outlet holes 422 along the circumferential direction thereof. The fan body 43 is arranged on the surface of the bottom shell 11, and the fan body 43 is located between the height of the air inlet hole 421 and the height of the air outlet hole 422.

In the present application, a cooling fan unit is also provided, the outer wall at the upper end of the heat-dissipating shell 42 is provided with multiple air inlet holes 421 along the circumferential direction thereof, and the outer wall at the lower end of the heat-dissipating shell 42 is provided with multiple air outlet holes 422 along the circumferential direction thereof. The heat-dissipating shell 42 is sleeved on the bottom shell 11, the fan body 43 is arranged on the surface of the bottom shell 11, and the fan body 43 is located between the height of the air inlet hole 421 and the height of the air outlet hole 422. Then the external air enters the heat-dissipating shell 42 from the air inlet hole 421 at the upper end of the heat-dissipating shell 42 and is discharged from the air outlet hole 422 at the lower end of the heat-dissipating shell 42. When the heat-absorbing unit works, it is close to the heat-dissipating surface of the CPU, thus the air discharged from the air outlet hole 422 can cool the heat dissipation of various electronic components such as MOS tubes and memory bars around the motherboard CPU. By using the device of the present application, the heat dissipation and cooling of the CPU and various electronic components such as MOS tubes and memory bars around the motherboard CPU can be realized, which can greatly improve the heat-dissipating efficiency and prolong the service life of the motherboard.

The fan body 43 includes a fan blade 425, a driving motor and a cylindrical fan mounting sleeve 431. The driving motor is drivingly connected with the fan blade 425 and drives the fan blade 425 to rotate, and the lower end of the fan mounting sleeve 431 is provided with a mounting bracket, and the driving motor is installed on the mounting bracket. The surface of the bottom shell 11 is provided with several connecting columns 110, the upper end of the connecting column 110 is provided with a first screw hole, and the mounting bracket is provided with a second screw hole aligned with the first screw hole. The fan mounting sleeve 431 is placed on the surface of the bottom shell 11 and passes through the first screw hole and the second screw hole respectively through the screws to realize the assembly with the heat-absorbing unit. The surface of the bottom shell 11 is also provided with multiple support columns, the fan mounting sleeve 431 is placed on the surface of the bottom shell 11, and the top of the support column butts against the bottom wall of the mounting bracket. In the present application, the connecting column and the mounting bracket can be detachably assembled through screws to facilitate the installation or disassembly of the fan main body 43 and the bottom shell 11. Moreover, the connecting column and the support column can support the fan body 43, such that a certain distance is maintained between the fan body 43 and the bottom shell 11, and sufficient air outlet space is left to improve the heat dissipation effect.

Preferably, the inner wall of the fan mounting sleeve 431 is provided with an LED lamp module. The LED lamp module includes a red LED lamp, a blue LED lamp, a green LED lamp and a white LED lamp. The user can connect the LED lamp module with the external control chip, and control the startup or shutdown of each LED lamp and the startup mode through the control chip. For example, the control chip can control the LED lamp module to achieve different types of light and shadow effects according to different types of music.

Preferably, in order to facilitate the user to watch the light and shadow effect of the LED lamp module, the upper end of the heat dissipation housing 42 is provided with an opening, and the opening is covered with a transparent cover plate 41, and the cover plate 41 plays a certain dust-proof role. Therefore, the user can see the colorful light effect of the fan through the upper opening and side ventilation hole of the heat heat-dissipating shell 42.

Preferably, in order to facilitate the placement of the cover plate 41, a circle of bump 423 is arranged on the inner wall of the opening, and the cover plate 41 is placed on the top wall of the bump 423.

The above embodiments only describe the preferred embodiments of the invention and do not limit the scope of the invention. Without departing from the design spirit of the invention, various modifications and improvements made by ordinary engineers and technicians in the art to the technical scheme of the invention shall fall within the protection scope determined by the claims of the invention.

## Claims

1. A water-cooled radiator, comprising a heat-absorbing unit connected with a heat-dissipating surface of a processor and a heat-dissipating unit communicated with the heat-absorbing unit, **characterized in that**: the heat-absorbing unit comprises an outer shell (10), a bottom shell (11), and a waterway cover plate (12) and a heat-absorbing bottom plate (14) connected in sequence from top to bottom;
wherein the bottom shell (11) is provided with a liquid inlet pipe (118) and a liquid outlet pipe (119) communicated with the heat-dissipating unit, and a pump body (22) is arranged between the heat-dissipating unit and the liquid inlet pipe (118); a first water cavity (1111) connected with the liquid inlet pipe (118) and a second water cavity (1112) flowing with the liquid outlet pipe (119) are encircled between the bottom shell (11) and the waterway cover plate (12), and the first water cavity (1111) and the second water cavity (1112) are independent of each other;
the heat-absorbing bottom plate (14) and the waterway cover plate (12) encircle a third water cavity (1113), wherein a surface of the heat-absorbing bottom plate (14) is fixedly provided with a heat-dissipating fin group (141), the heat-dissipating fin group (141) is arranged in the third water cavity (1113), a surface of the waterway cover plate (12) is provided with a first water-passage hole (122) for connecting the first water cavity (1111) and the third water cavity (1113), and a second water-passage hole (123) for connecting the second water cavity (1112) and the third water cavity (1113), wherein the first water-passage hole (122) extends along a direction perpendicular to a length of the heat-dissipating fin group (141), and the second water-passage hole (123) of the waterway cover plate (12) is arranged at both ends of the corresponding heat-dissipating fin group (141).

2. The water-cooled radiator according to claim 1, **characterized in that**: a liquid inlet (114) is arranged at a connection between the liquid inlet pipe (118) and the first water cavity (1111); and a liquid outlet (113) is arranged at a connection between the liquid outlet pipe (119) and the second water cavity (1112).

3. The water-cooled radiator according to claim 1, **characterized in that**: a bottom of the bottom shell (11) is provided with a water-passage trough (111), and the water-passage trough (111) is provided with a "Ω" shaped water baffle (112), wherein an inner wall of the water-passage trough (111), an inner side of the water baffle (112) and the waterway cover plate (12) encircle the first water cavity (1111), and the inner wall of the water-passage trough (111), an outer side of the water baffle (112) and the waterway cover plate (12) encircle the second water cavity (1112); the inner wall of the water-passage trough (111) is provided with a limit bump (117), an outer side of the waterway cover plate (12) is provided with a limit groove (124) corresponding to the limit bump (117), the waterway cover plate (12) is arranged in the water-passage trough (111), and the limit bump (117) is inserted in the limit groove (124).

4. The water-cooled radiator according to claim 1, **characterized in that**: the bottom surface of the waterway cover plate (12) is provided with a placement groove (121), the heat-absorbing bottom plate (14) is arranged at a bottom of the waterway cover plate (12), the heat-dissipating fin group (141) is arranged in the placement groove (121), the first water-passage hole (122) is arranged in a middle of the bottom of the placement groove (121) and is aligned with the center of the heat-dissipating fin group (141), at the same time, the second water-passage hole (123) is arranged on both sides of the bottom of the placement groove (121) and is aligned with both ends of the heat-dissipating fin group (141), and a depth of the placement groove (121) is equal to a height of the heat-dissipating fin group (141).

5. The water-cooled radiator according to claim 1, **characterized in that**: a sealing groove is arranged at a connection between the bottom shell (11) and the heat-absorbing bottom plate (14), a sealing ring (13) is embedded in the sealing groove, and a cross-sectional area of the sealing ring (13) is greater than that of the sealing groove.

6. The water-cooled radiator according to claim 1, **characterized in that**: the heat-absorbing unit further comprises an arc-shaped support (18), wherein both ends of the arc-shaped support (18) are provided with hooks, wherein an outer surface of the bottom shell (11) is provided with a circle of first bumps (116), the outer surface of the bottom shell (11) is evenly provided with a plurality of second bumps (115) under the first bumps (116) along a circumferential direction, the outer surface of the bottom shell (11) located between the first bump (116) and the second bump (115) is provided with a slot corresponding to the hook, and the arc-shaped support (18) is clamped between the first bump (116) and the second bump (115), and is hooked with the slot through hooks at both ends to realize connection with the bottom shell (11).

7. The water-cooled radiator according to claim 1, **characterized in that**: the heat-dissipating unit comprises a heat-dissipating water row (21), a first adapter (151), a second adapter (152), a first pipe sleeve (161), a second pipe sleeve (162), a first braided pipe (241)and a second braided pipe(242), wherein the liquid outlet pipe (119) is communicated with the first adapter (151), the first adapter (151) is communicated with one end of the first braided pipe(241) through the first pipe sleeve (161), and the other end of the first braided pipe(241) is communicated with the heat-dissipating water row (21); the liquid inlet pipe is connected with the second adapter (152), the second adapter (152) is connected with one end of the second braided pipe(242) through the second pipe sleeve (162), the other end of the second braided pipe(242) is connected with a water outlet end of the pump body (22), and a water inlet end of the pump body (22) is communicated with the heat-dissipating water row (21).

8. The water-cooled radiator according to claim 1, **characterized in that**: the outer shell (10) comprises a transparent cover plate (101), an upper mirror (102), an aluminum upper cover (103), a transparent light guide (104), a middle trim plate (105), a lower mirror cover (106), a LOGO support (107), a lower cover (108) and a PCB board (109), wherein the transparent cover plate (101), the aluminum upper cover (103), the middle trim plate (105) and the lower cover (108) are connected in sequence from top to bottom, and the lower cover (108) is covered on the surface of the bottom shell (11); the upper mirror (102) cover is arranged between the transparent cover plate (101) and the aluminum upper cover (103), the transparent light guide (104) is arranged between the aluminum upper cover (103) and the middle trim plate (105), the lower mirror cover (106) and the LOGO support (107) are arranged between the middle trim plate (105) and the lower cover (108), and the PCB board (109) is arranged between the lower cover (108) and the bottom shell (11).

9. The water-cooled radiator according to claim 1, **characterized in that**: the outer shell (10) comprises a fan body (43) and a cylindrical heat-dissipating shell (42) sleeved on the bottom shell (11), wherein an outer wall at an upper end of the heat-dissipating shell (42) is provided with a plurality of air inlet holes (421) along the circumferential direction thereof, and an outer wall at a lower end of the heat-dissipating shell (42) is provided with a plurality of air outlet holes (422) along the circumferential direction thereof; the fan body (43) is arranged on the surface of the bottom shell (11), and the fan body (43) is located between a height of the air inlet hole (421) and a height of the air outlet hole (422).

10. The water-cooled radiator according to claim 9, **characterized in that**: the fan body (43) comprises a fan blade (425), a driving motor and a cylindrical fan mounting sleeve (431), the driving motor is drivingly connected with the fan blade (425) and drives the fan blade (425) to rotate, and a lower end of the fan mounting sleeve (431) is provided with a mounting bracket, and the driving motor is installed on the mounting bracket; a surface of the bottom shell (11) is provided with several connecting columns (110), an upper end of the connecting column (110) is provided with a first screw hole, and the mounting bracket is provided with a second screw hole aligned with the first screw hole, wherein the fan mounting sleeve (131) is placed on the surface of the bottom shell (11) and passes through the first screw hole and the second screw hole respectively through the screws to realize the assembly with the heat-absorbing unit; an inner wall of a fan mounting sleeve (431) is provided with an LED lamp module, wherein the LED lamp module comprises a red LED lamp, a blue LED lamp, a green LED lamp and a white LED lamp.
